Europäisches Patentamt

European Patent Office

Office européen des brevets

(19)

(11) EP 0 559 684 B1

(12) EUROPÄISCHE PATENTSCHRIFT

(45) Veröffentlichungstag und Bekanntmachung des Hinweises auf die Patenterteilung:
**13.05.1998 Patentblatt 1998/20**

(21) Anmeldenummer: **91920219.2**

(22) Anmeldetag: **21.11.1991**

(51) Int Cl.6: **H03H 11/04**

(86) Internationale Anmeldenummer:
**PCT/EP91/02196**

(87) Internationale Veröffentlichungsnummer:
**WO 92/10031 (11.06.1992 Gazette 1992/13)**

(54) **UNIVERSALFILTER**

UNIVERSAL FILTER

FILTRE UNIVERSEL

(84) Benannte Vertragsstaaten:
**DE ES FR GB IT**

(30) Priorität: **29.11.1990 DE 4038111**

(43) Veröffentlichungstag der Anmeldung:
**15.09.1993 Patentblatt 1993/37**

(73) Patentinhaber: **Deutsche Thomson-Brandt GmbH 78003 Villingen-Schwenningen (DE)**

(72) Erfinder:
• **RIEGER, Martin
  D-7210 Rottweil-Neukirch (DE)**

• **ROTH, Sabine
  D-7730 Villingen (DE)**

(56) Entgegenhaltungen:
**DE-A- 3 830 410**

• **IEEE TRANSACTIONS ON CIRCUITS AND SYSTEMS. Bd. 35, Nr. 8, August 1988, NEW YORK US Seiten 936 - 945; SANCHEZ-SINENCIO ET AL: 'Generation of Continuous-Time Two Integrator loop OTA Filter Structures' siehe Seite 936, linke Spalte, Zeile 15 - Zeile 32 siehe Seite 939, linke Spalte, Zeile 10 - Zeile SA 53246 03015 siehe Seite 939, rechte Spalte, Zeile 31 - Seite 941, linke Spalte, Zeile 2; Abbildung 11**

EP 0 559 684 B1

**Beschreibung**

Es ist bekannt, bei jeder Art von Filtern, insbesondere von aktiven Filtern wie Tiefpaß, Hochpaß, Bandpaß, Bandsperre (Falle oder Trap-Filter), Allpaß usw. spezielle/ möglichst einfache Schaltungen anzugeben. Es tritt jedoch gelegentlich die Forderung auf, mit einer einzigen Schaltung alle oben genannten Filterarten und auch noch allgemeinere Filterfunktionen gemäß der Übertragungsfunktion eines Filterblocks zweiter Ordnung der allgemeinen Form

$$A(P) = \frac{d_0 + d_1 P + d_2 P^2}{c_0 + c_1 P + c_2 P^2} \qquad\qquad Gl.1.1$$

mit beliebigen Filterkoeffizienten $d_0$, $d_1$, $d_2$, $c_0$, $c_1$ und $c_2$ zu realisieren. Solche Filter werden Universalfilter genannt und stellen aktive Filter dar.

Eine Schaltungsausführung für Universalfilter ist aus Halbleiterschaltungstechnik, neunte überarbeitete und erweiterte Auflage, U. Tietze, Ch. Schenk, Springerverlag 1989, Seite 444 dort in Abbildung 14.42 bekannt. Bei einer derartigen Schaltung lassen sich einzelne Koeffizienten unabhängig voneinander einstellen, da jeder Koeffizient nur von einem Bauelement abhängt.

Außerdem sind in der oben genannten Quelle in der Schaltung Filter mit einstellbaren Parametern aufgezeigt, bei denen die Resonanzfrequenz, die Güte und die Verstärkung bei der Resonanzfrequenz unabhängig voneinander eingestellt werden können.

Der Vorteil eines solchen Universalfilters besteht insbesondere darin, daß es je nachdem, welchen Ausgang man verwendet, gleichzeitig als selektives Filter, Sperrfilter oder Falle (Trap), als Tiefpaß und/oder Hochpaß oder als Hochpaß arbeitet. Je nach Dimensionierung einzelner Bauteile läßt sich jeweils ein Filtertyp bestimmen sowie die Filtercharakteristik ändern. Außerdem lassen sich bei dem gegebenen Filtertyp die Grenzfrequenz und die Verstärkung unabhängig voneinander durchstimmen.

Auch beim Betrieb als Bandpass bzw. Bandsperre lassen sich die Resonanzfrequenz, die Verstärkung und die Güte variieren, ohne daß sie sich gegenseitig beeinflussen.

Universalfilter sind als integrierte Schaltungen erhältlich, bei denen man außen nur ein paar Widerstände zur Festlegung des Filtertyps und Grenzfrequenz anschließen muß.

Die aus der oben erwähnten Quelle bekannten Schaltungen haben jedoch den Nachteil, daß sie aus relativ vielen Bauelementen aufgebaut sind, was eine Integration in einer Halbleiterschaltung aufwendig und damit kostspielig macht.

Aus DE-A-38 30 410 ist eine Aktivfiltersignaleinstellschaltung zum Einstellen des Frequenzgangs einer elektrischen Schaltung bekannt. Diese Schaltung weist zur Erzielung einer perfekten Durchgangskennlinie von einer Videosignal-Verarbeitungsschaltung zwei Operationsverstärker auf, die Eingangs- und Ausgangssignal differentiell verarbeiten. Weiterhin sind Regelverstärker vorhanden, deren Verstärkungen zum Einstellen des Frequenzgangs veränderbar sind.

Es ist Aufgabe der Erfindung, ein Universalfilter auszubilden, das einen einfachen und geringen Schaltungsaufbau aufweist.

Die Aufgabe wird erfindungsgemäß mit einem Universalfilter, das die Merkmale nach Anspruch 1 aufweist, gelöst. Vorteilhafte Weiterbildungen sind in den Unteransprüchen beschrieben.

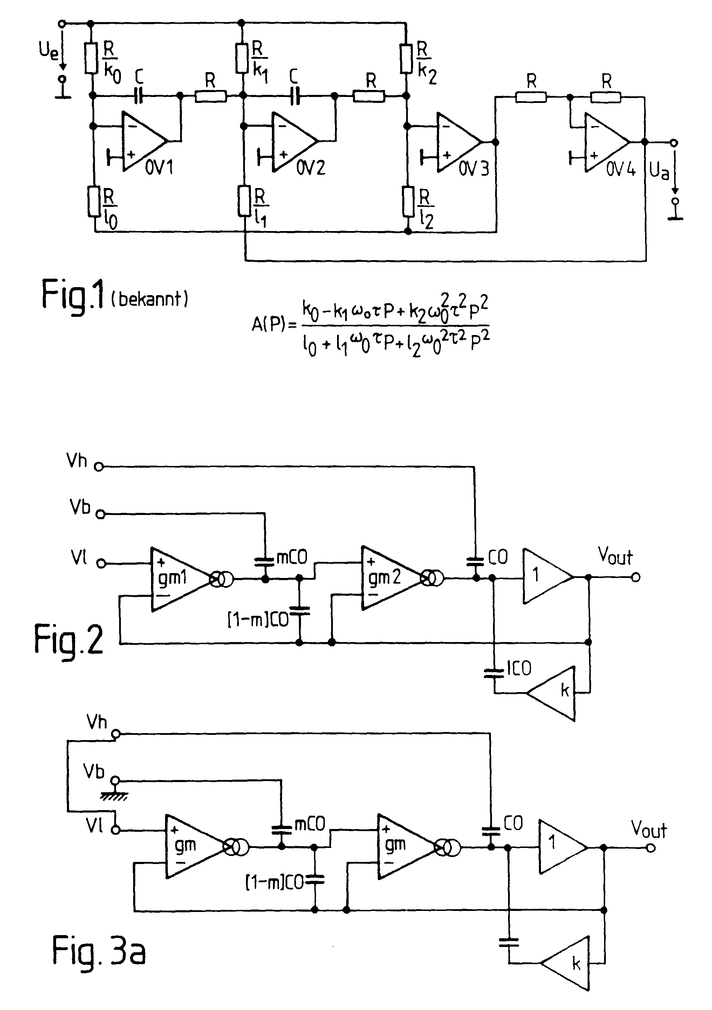

Während für ein aktives Universalfilter nach Tietze-Schenk Seite 444 (Figur 1) 10 Widerstände, 2 Kapazitäten und 4 Operationsverstärkernotwendig sind , werden bei der erfindungsgemäßen Schaltung nur 2 Konduktanz-Verstärker, 4 Kapazitäten, 1 Spannungsfolger und 1 Verstärker K mit einer Verstärkung k benötigt. Der Schaltungsaufwand ist also erheblich reduziert.

Insbesondere läßt sich mit der erfindungsgemäßen Universalfilter-Sruktur in hervorragender Weise ein Bandpaßfilter oder ein Sperrfilter aufbauen und je nach gewünschter Mittenfrequenz, Güte, Flankensteilheit und Verstärkung usw. durchstimmen.

Die Erfindung wird nachstehend anhand mehrerer zeichnerisch dargestellter Ausführungsbeispiele näher erläutert. In den Zeichnungen stellen dar:

Fig. 1      Universalfilter zweiter Ordnung mit unabhängig einstellbaren Koeffizienten (bekannt),
Fig. 2      ein erfindungsgemäßes Universalfilter,
Fig. 3a      das Universalfilter nach Fig. 2 als Sperrfilter oder Falle geschaltet,
Fig. 3b      Frequenzgänge des Sperrfilters nach Fig. 3a bei Variationen der Größen m und k,
Fig. 4a      das Universalfilter nach Fig. 2 als Bandpaß geschaltet,
Fig. 4b      Frequenzgänge eines Bandpaßfilters nach Figur 4a bei der Variierung von m und des Verhältnisses von gm1 zu gm2,

Fig. 5 ein Universalfilter nach Fig. 2 als Tiefpaß geschaltet,

Fig. 6 ein Universalfilter nach Fig. 2 als Hochpaß geschaltet,

Fig. 7 ein Universalfilter nach Fig. 2 als Allpaß geschaltet,Fig. 8 Universalfilter mit unabhängig einstellbaren Parametern (bekannt).

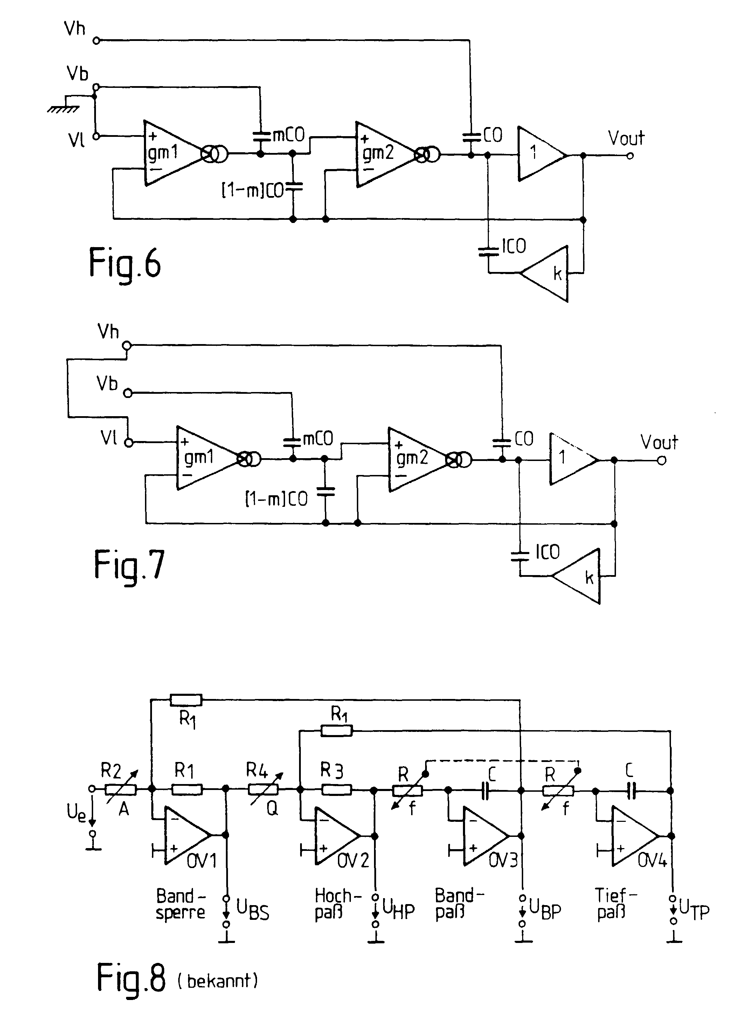

Figur 1 zeigt ein Universalfilter zweiter Ordnung mit unabhängig einstellbaren Koeffizienten sowie der zugehörigen Übertragungsfunktion A(P), wie er aus dem Buch "Halbleiter-Schaltungtechnik", neunte bearbeitete und erweiterte Auflage, U. Tietze, Ch. Schenk; Springerverlag Berlin 1989, Seite 444-447 bekannt ist. Dieses Universalfilter weist einen relativ komplizierten und aufwendigen Aufbau auf. Immerhin sind zu Realisierung dieses Universalfilters vier Operationverstärker, zehn Widerstände und zwei Kapazitäten nötig. Ein solches Filter läßt sich je nach Variierung der Koeffizienten k0, k1, k2, 10, 11 und 12 für eine bestimmte Filterart einstellen. Als Filterarten sind insbesondere Tiefpaß-, Hochpaß-, Bandpaß-, Allpaßfilter oder Bandsperre genannt. Bei der Einstellung von verschiedenen Filterarten und der gleichzeitigen Variierung der Filterparameter oder- Charakteristik ist in Fig. 8 eine Universalfilter zweiter Ordnung mit unabhängig einstellbaren Parametern (siehe Buch Halbleiter-SchaltungtechnikS. 446) aufgezeigt. Dieses Filter weist 4 Operationsverstärker, vier feste und vier einstellbare Widerstände und zwei Kapazitäten sowie vier Ausgänge (bei einem Chip vier Pins) und einen Eingang auf. Jeder Ausgang stellt eine Abzweigung für einen bestimmten Filtertyp dar. Auch bei diesem Universalfilter ist der Schaltungsaufwand und damit der Overhead für eine integrationsfähige Schaltung relativ groß.

Figur 2 zeigt die Grundstruktur eines erfindungsgemäßen Universalfilters in Biquad-Filter-Stuktur. Das Universalfilter weist zwei Konduktanz-Verstärker GM1und GM2, sowie vier Kapazitäten (Kondensatoren) mC0, (1-m)C0, C0 und lC0, sowie einen Verstärker K und einen Spannungsfolger SP auf, sowie drei Eingänge Vh, Vb, und Vl sowie einen Ausgang Voutauf. Der Spannungsfolger SP weist einen hochohmigen Eingang auf und ist praktisch als Impedanzwandler mit der Verstärkung 1 ausgebildet. Der Eingang Vl ist mit dem nicht-invertierenden Eingang des Trans-Konduktanz-Verstärkers GM1 mit der Verstärkung gm1 verbunden. Der Eingang Vb ist über die Kapazität mC0 mit dem Ausgang des Trans-Konduktanz-Verstärkers GM1, mit dem nicht invertierenden Eingang des 2. Trans-Konduktanz-Verstärkers GM2 mit der Verstärkung gm2. sowie mit dem Kondensator (1-m)C0 verbunden. Der Eingang Vh ist über den Kondensator CO mit dem Ausgang des Trans-Konduktanz-Verstärkers GM2, mit dem Eingang des Spannungsfolgers mit hochohmigem Eingang und mit dem Rückführungskondensator lC0verbunden. Der Ausgang Vout ist mit dem Ausgang des Spannungsfolgers, mit den invertierenden Eingängen der beiden Trans-Konduktanz-Verstärker GM1 und GM2, mit dem Kondensator (1-m) C0 sowie mit dem Eingang des Verstärkers K mit der Verstärkung k verbunden. Der Ausgang des Verstärkers ist mit der Kapazität lC0 verbunden.Alle Verbindungen sind elektrisch leitend ausgebildet.

Für die Spannung Vout ergibt sich in der Form nach der Formel Gl. 1.1:

$$Vout = \frac{Vl + m \cdot (p/p0) \cdot Vb + (p^2/p0^2) \cdot (gm1/gm2) \cdot Vh}{1 + m \cdot (p/p0) + (p^2/p0^2) \cdot (gm1/gm2) \cdot (1 + l - l \cdot k)} \qquad Gl.2.1$$

Je nach Eingangsbelegung der drei Eingänge Vl, Vb und Vh ist das Universalfilter entweder als Hochpaßfilter oder Tiefpaßfilter oder Bandpaßfilter oder Allpaßfilter oder Bandsperre (Trap) oder sonstiges aktives Filter ausgebildet. Je nach Dimensionierung der Parameter gm1, gm2, m, l, k lassen sich die verschiedenen Filtercharakteristika wie Güte, Verstärkung, Mittenfrequenz, Flankensteilheit usw. einstellen.

Fig. 3a zeigt das Universalfilter nach Fig. 2 als Trap-Filter oder Bandsperre geschaltet. Die Eingänge Vl und Vh sind miteinander verbunden. Diese beiden Eingänge bilden den gemeinsamen Eingang der Schaltung. Der Eingang Vb ist auf Masse gelegt. Dadurch ergibt sich für Vout

$$Vout = \frac{Vin(1 + (p^2/p0^2))}{1 + m \cdot (p/p0) + (p^2/p0^2)(1 + l - l \cdot k)} \qquad Gl.2.1.A$$

wobei der Quotient von gm1/gm2 der Gleichung 2.1 = eins gesetzt ist und Vl = Vh = Vin ist.

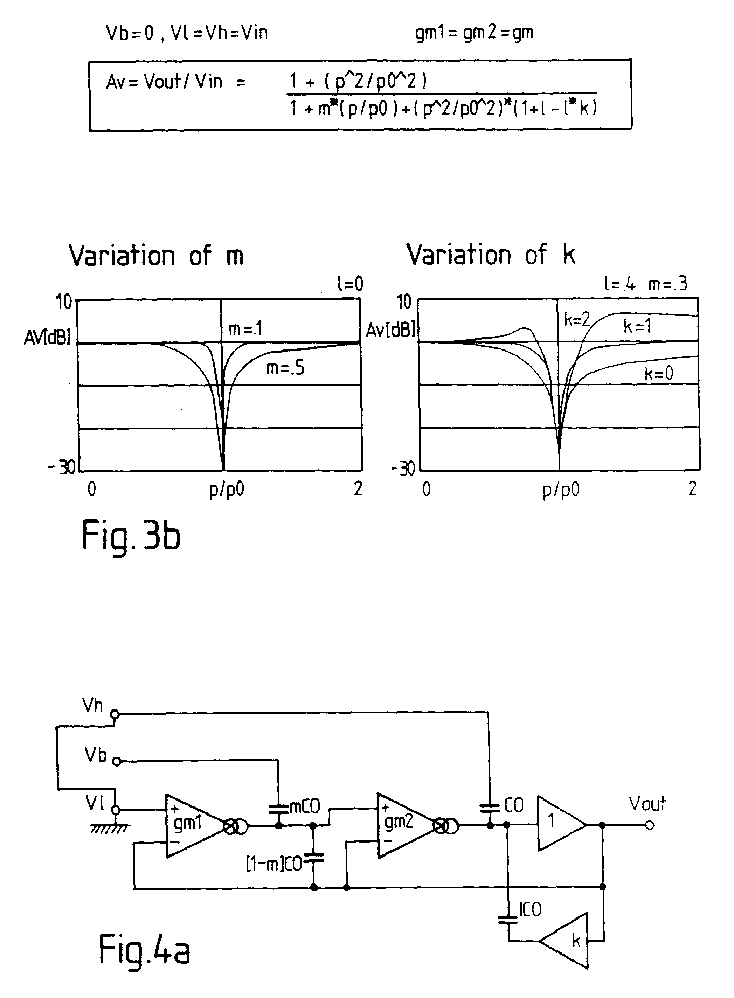

Fig. 3b zeigt die Frequenzgänge des Trap-Filters einmal bei 1 = null und bei der Variation von m und einmal bei 1 = vier, m = drei und einer Variation von k, sowie die Übertragungsfunktion der Schaltung nach Fig. 3a. Je größer m ist, desto steiler verläuft bei der Mittenfrequenz des Trap-Filters die Pegelabsenkung. Bei der Variation von k zeigt der Frequenzgang des Trap-Filters: Je größer k ist, desto stärker fallen die Überhöhungen in der Frequenzmitte aus und um so steiler wird der Pegelabfall.

In der Fig. 4a ist das Universalfilter nach Fig. 2 als Bandpaßfilter geschaltet. Vh und Vl sind wiederum miteinander verbunden und liegen jetzt auf Masse. Der Parameter 1 ist zu Null gesetzt. Für die Ausgangsspannung Vout ergibt sich

dann:

$$Vout = \frac{m \cdot (P/P0)Vin}{1+m \cdot (p/p0)+(p^2/p0^2) \cdot (gm1/gm2)} \qquad Gl.2.1.B$$

wobei Vb= Vingilt.

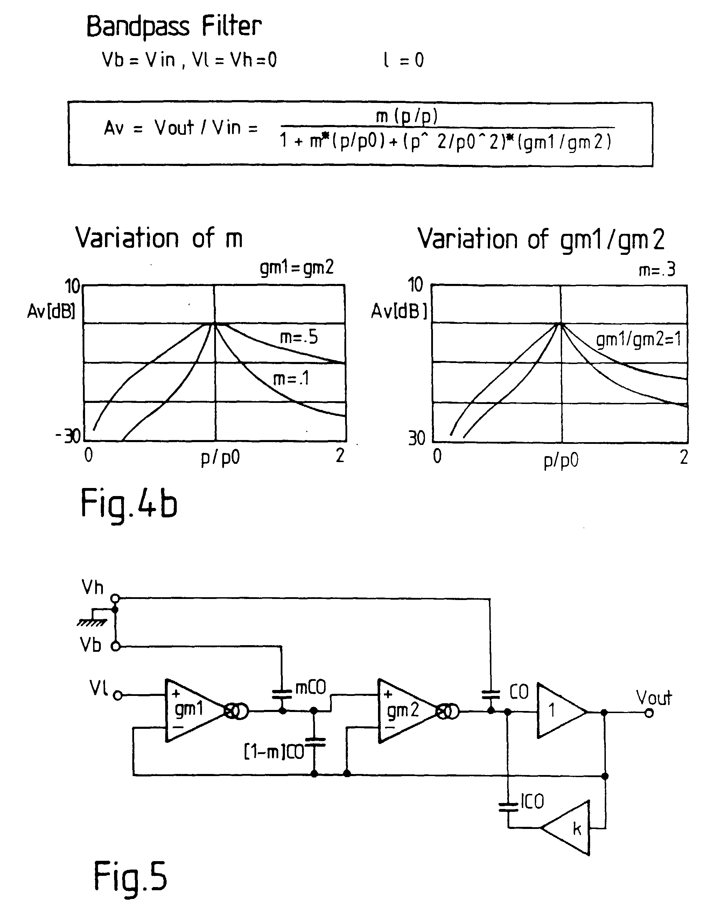

In der Fig. 4b sind die Frequenzgänge des Bandpaß-Filters einmal bei der Variation von m und einmal bei der Variation von gm1/gm2 gezeigt, sowie die Übertragungsfunktion des Bandpaßfilters. Bei der Variation von m ist gm1 = gm2. Bei der Variation von gml/gm2 ist m = drei. Je größer m desto flacher ist der Verlauf des Frequenzganges im Bereich der Mittenfrequenz. Je größer das Verhältnis von gm1/gm2 desto steiler ist der Abfall des Frequenzganges an den Flanken.

In der Fig. 5 ist das Universalfilter nach Fig. 2 als Tiefpaßgeschaltet. Die Eingänge VH und Vb sind miteinander verbunden und auf Masse gelegt. I ist zu Null gesetzt. Dann ergibt sich für Vout:

$$Vout = \frac{Vl}{1+m \cdot (p/p0)+(p^2/p0^2) \cdot (gm1/gm2)} \qquad Gl.2.1.C$$

In der Fig. 6 ist das Universalfilter nach Fig. 2 als Hochpaß geschaltet. Der Eingang Vl ist mit dem Eingang Vb verbunden und auf Masse gelegt. 1 ist zu Null gesetzt. Dann ergibt sich für Vout:

$$Vout = \frac{(p^2/p0^2) \cdot (gm1/gm2) \cdot Vh}{1+m \cdot (p/p0)+(p^2/p0^2) \cdot (gm1/gm2)} \qquad Gl.2.1.D$$

In der Fig. 7 ist das Universalfilter nach Fig. 2 als Allpass-Filter geschaltet. I ist wieder zu 0 gesetzt. Die beiden Eingänge VH und Vl sind miteinander verbunden. Es gilt für die Eingänge: Vb = -Vl = -Vh. Dann ergibt für Vout:

$$Vout = \frac{Vl-m \cdot (p/p0) \cdot Vb+(p^2/p0^2) \cdot (gm1/gm2) \cdot Vh}{1+m \cdot (p/p0)+(p^2/p0^2) \cdot (gm1/gm2).} \qquad Gl.2.1.E$$

Für alle Formeln gilt: p0 = gm1/C0. Dei Unterschied zwischen einem Operationsverstärker und einem (Operations-) Trans-Konduktanz-Verstärker (OTA) liegt darin, daß ein Operationsverstärker den Spannungsunterschied (Differenzspannung) am Eingang bis zu 100000 mal verstärkt und an seinem Ausgang diese verstärkte Spannung zur Verfügung stellt, während der OTA zwar auch die Differenzspannung am Eingang verstärkt, allerdings ist der "Verstärkungsfaktor" einstellbar und am Ausgang erscheint ein Strom statt einer Spannung. Der Verstärkungsfaktor des OTA wird in mA/V ausgedrückt und als Steilheit bezeichnet. Als integrierte Halbleiterbausteine sind die Typen LM 13600 und LM 13800 von RCA bekannt.

Bei allen Schaltungen in den Fig. 2 - 7 läßt sich über das Verhältnis von P/PO die jeweilige Mittenfrequenz oder Grenzfrequenz der Filter ändern. Die Güte des Bandpasses läßt sich durch das Verhältnis 1 : m stufenlos einstellen.

Schaltungen nach der oben genannten Art lassen sich insbesondere bei Fernsehempfängern, bei Mehr-Norm Fernsehempfängern, Rundfunkempfängern und Messgeräten verwenden. Bei Mehr-NormFernseh-Empfängern sind sie deshalb in geeigneter Weise zu verwenden, da einmal bei einer Frequenz ein Nutzsignal ist, wo bei einer anderen Norm ein Störsignal auftaucht. Es kann also mit der Erfindung je nach Bedarf ein Signal unterschiedlich unterdrückt oder durchgelassen werden. Dadurch lassen sich diese Schaltungen sinnvoll für flexibles, analoges Signalprozessing verwenden.

Durch ihre Einfachheit in der Schaltungsstruktur wird der Schaltungsaufwand - der sogenannte Overhead - gering gehalten und der gesamte Intergrationsprozeß erleichtert.

## Patentansprüche

1. Universalfilter in Biquad-Filter-Struktur mit drei Eingängen Vh, Vb und Vl, sowie einem Ausgang Vout, gekennzeichnet durch folgende Merkmale:

  - der Eingang Vl ist mit dem nicht-invertierenden Eingang eines ersten Trans-Konduktanz-Verstärkers Gm1 mit der Verstärkung gml verbunden;

- der Eingang Vb ist über einen Kondensator mCO mit dem Ausgang des Trans-Konduktanz-Verstärkers Gm1, mit dem nicht-invertierenden Eingang eines zweiten Trans-Konduktanz-Verstärkers Gm2 mit der Verstärkung gm2, sowie mit einem Kondensator (1-m)C0 verbunden;

- der Eingang Vh ist über einen Kondensator CO mit dem Ausgang des Trans-Konduktanz-Verstärkers Gm2, mit dem Eingang eines Spannungsfolgers mit hochohmigem Eingang und einem Rückführungskondensator lC0 verbunden;

- der Ausgang Vout ist mit dem Ausgang des Spannungsfolgers, mit den invertierenden Eingängen der beiden Trans-Konduktanz-Verstärker Gm1 und Gm2, mit dem Kondensator (1-m)C0, sowie mit dem Eingang eines Verstärkers K mit der Verstärkung k verbunden, dessen Ausgang mit dem Kondensator lC0 verbunden ist;

- je nach Eingangsbelegung der Eingänge Vh, Vb und Vl ist das Universalfilter entweder als Hochpaßfilter oder Tiefpaßfilter oder Bandpaßfilter oder Bandsperre (Trapfilter) oder Allpaßfilter oder sonstiges aktives Filter ausgebildet;

- je nach Dimensionierung der Parameter gm1, gm2, m, 1 und k sind verschiedene Filtercharakteristika wie Güte, Flankensteilheit, Mittenfrequenz, Verstärkung usw. einstellbar.

2. Universalfilter nach Anspruch 1, dadurch gekennzeichnet, daß allgemein für den Ausgang des Universalfilters gilt:

$$\text{Vout} = \frac{Vl+m\cdot(p/p0)\cdot Vb+(p^2/p0^2)\cdot(gm1/gm2)\cdot Vh}{1+m\cdot(p/p0)+(p^2/p0^2)\cdot(gm1/gm2)\cdot(1+l-l\cdot k)}$$

wobei gilt: P0 = gm1/C0.

3. Universalfilter nach Anspruch 1, dadurch gekennzeichnet, daß der Universalfilter als integrierte Schaltung ausgebildet ist.


## Claims

1. Universal filter of biquad filter construction having three inputs Vh, Vb and V1 and an output Vout, characterised by the following features:

- the input V1 is connected to the non-inverting input of a first transconductance amplifier Gml having an amplification factor of gm1;

- the input Vb is connected via a capacitor mCO to the output of the transconductance amplifier Gm1, to the non-inverting input of a second transconductance amplifier Gm2 having an amplification factor of gm2 and also to a capacitor (1-m)C0;

- the input Vh is connected via a capacitor CO to the output of the transconductance amplifier Gm2, to the input of a voltage follower having a high impedance input and a feedback capacitor 1C0;

- the output Vout is connected to the output of the voltage follower, to the inverting inputs of the two transconductance amplifiers Gm1 and Gm2, to the capacitor (1-m)C0 and also to the input of an amplifier having an amplification factor of k and the output of which is connected to the capacitor 1C0;

- the universal filter is in the form either of a high pass filter or a low pass filter or a band pass filter or a bandstop filter (trap filter) or an all-pass filter or some other form of active filter in dependence on the input assignment of the inputs Vh, Vb and V1;

- different filter characteristics such as the Q factor, edge slope, centre frequency, amplification factor, etc can be set in dependence on the dimensions of the parameters gm1, gm2, m, l and k.

**2.** Universal filter in accordance with Claim 1, characterised in that, in general, the following relationship applies for the output of the universal filter:

$$Vout = \frac{V1 + m^*(p/p0)^*Vb + (p^2/p0^2)^*(gm1/gm2)^*Vh}{1 + m^*(p/p0) + (p^2/p0^2)^*(gm1/gm2)^*(1+l-1^*k)}$$

wherein PO = gm1/CO.

**3.** Universal filter in accordance with Claim 1, characterised in that the universal filter is constructed in the form of an integrated circuit.

**Revendications**

**1.** Filtre universel à structure de filtre bi-quad avec trois entrées Vh, Vb et Vl, ainsi qu'une sortie Vout présentant les caractéristiques suivantes :

- l'entrée Vl est reliée à l'entrée non inversante d'un premier amplificateur de conductance GM1 avec l'amplification gm1 ;

- l'entrée Vb est reliée, via un condensateur mCO, à la sortie de l'amplificateur de conductance GM1, à l'entrée non inversante d'un deuxième amplificateur de conductance GM2 avec l'amplification gm2, ainsi qu'à un condensateur (1-m)CO;

- l'entrée Vh est reliée, via le condensateur CO, à la sortie de l'amplificateur de conductance GM2, à l'entrée du contrôleur de tension avec entrée à haute résistance et au condensateur de rétroaction ICO ;

- la sortie Vout est reliée à la sortie du contrôleur de tension, aux entrées inversantes des deux amplificateurs de conductance GM1 et GM2, au condensateur (1-m)CO, ainsi qu'à l'entrée de l'amplificateur K avec l'amplification k. La sortie de l'amplificateur K est reliée au condensateur ICO ;

- selon la configuration des trois entrées Vh, Vb et Vl, le filtre universel est de type passe-haut, passe-bas, passe-bande, passe-tout, coupe-bande (piège) ou de tout autre type de filtre actif;

- en fonction de la dimension des paramètres gm1, gm2, m, l, k, il est possible de régler les différentes caractéristiques du filtre telles que la qualité, l'amplification, la moyenne fréquence, la raideur de flanc, etc.

**2.** Filtre universel selon la revendication 1, caractérisé en ce que la formule ci-dessous est généralement applicable à la sortie du filtre universel :

$$Vout = \frac{Vl\text{-}m \cdot (p/p0) \cdot Vb + (p^2/p0^2) \cdot (gm1/gm2) \cdot Vh}{1+m \cdot (p/p0)+(p^2/p0^2) \cdot (gm1/gm2) \cdot (1+l\text{-}l \cdot k)}$$

où P0 = gm1/CO.

**3.** Filtre universel selon la revendication 1, caractérisé en ce que le filtre universel est réalisé sous la forme d'un circuit intégré.

Fig.1 (bekannt)

$$A(P) = \frac{k_0 - k_1 \omega_0 \tau P + k_2 \omega_0^2 \tau^2 P^2}{l_0 + l_1 \omega_0 \tau P + l_2 \omega_0^2 \tau^2 P^2}$$

Fig.2

Fig. 3a

$$Vb = 0 \ , \ Vl = Vh = Vin \qquad\qquad gm1 = gm2 = gm$$

$$Av = Vout / Vin \ = \ \frac{1 + ( p\char`^2 / p0\char`^2 )}{1 + m^{*}( p / p0 ) + ( p\char`^2 / p0\char`^2 )^{*}( 1 + l - l^{*} k )}$$

## Variation of m

## Variation of k

Fig. 3b

Fig. 4a

## Bandpass Filter

$Vb = Vin$, $Vl = Vh = 0$ $\qquad l = 0$

$$Av = Vout / Vin = \frac{m(p/p)}{1 + m^*(p/p0) + (p^2/p0^2)^*(gm1/gm2)}$$

## Variation of m

$gm1 = gm2$

m=.5

m=.1

## Variation of gm1/gm2

m=.3

gm1/gm2=1

## Fig.4b

## Fig.5

Fig.6

Fig.7

Fig.8 (bekannt)

10